# EUROPEAN PATENT APPLICATION

(11) **EP 1 522 897 A2**
(43) Date of publication of application: **13.04.2005**
(21) Application number: 04023393.4
(22) Date of filing: 01.10.2004
(51) Int. Cl.: G03F 7/30, B41N 3/00

(54) **Developer system**

(30) Priority: 08.10.2003 US 681575
(71) Applicant: Kodak Polychrome Graphics LLC, Norwalk, Connecticut 06851 (US)
(72) Inventor: Miller, Gary Roger, Fort Collins, CO 80528 (US); Kelim, Melanie, Loveland, CO 80537 (US); Dunn, Jerry, Milliken, CO 80543 (US); Poland, Eugene, Ault, CO 80610 (US)
(74) Representative: VOSSIUS & PARTNER

(57) **Abstract**

The present invention provides a system for developing printing plate precursors. In one embodiment, the system includes a developer unit (115) adapted to apply developer to printing plate precursors, a replenisher unit (150) for controllably delivering replenisher to the developer unit (115) and a regenerator unit (165) for controllably delivering regenerator to the developer unit (115). The system may controllably deliver sufficient amounts of the replenisher and/or regenerator to maintain the volume and/or activity of the developer in the developer unit.

## Description

The art of lithographic printing is based on the immiscibility of ink and water. A lithographic printing plate is composed of ink receptive regions, commonly referred to as the "image area," and hydrophilic regions. When the surface of the printing plate is moistened with water and printing ink is applied, the hydrophilic regions retain the water and repel the printing ink, and the image area retains the printing ink and repels the water. The printing ink retained on the image area may then be transferred to the surface of a material upon which the image is to be reproduced. Typically, the ink is first transferred to an intermediate blanket, which in turn transfers the ink to the desired surface.

Lithographic printing plates precursors typically include a radiation-sensitive coating applied over the hydrophilic surface of a substrate. Conventional radiation-sensitive coatings include photosensitive components dispersed within an organic polymeric binder. After a portion of the coating is exposed to radiation (commonly referred to as imagewise exposure), the exposed portion becomes either more developable or less developable in a particular liquid than an unexposed portion of the coating. A printing plate precursor is generally considered a positive-working plate if, after exposure to radiation, the exposed portions or areas of the radiation-sensitive coating become more developable and are removed in the developing process to reveal the hydrophilic surface. Conversely, the precursor is considered a negative-working plate if the exposed portions or areas become less developable in the developer and the unexposed portions or areas are removed in the developing process.

After imaging, the precursors are contacted with a developer to remove either the exposed or unexposed portions of the radiation-sensitive coating to form a printing plate. This process is generally performed using a developer system, which receives imaged printing plate precursors, and then contacts the precursors with a developer either by spraying the developer onto the precursor or by immersing the precursor in a developer bath. During development, portions of the radiation-sensitive composition are removed from the precursor to reveal the substrate surface, and portions remain on the plate to provide an ink-receptive image. Oftentimes, the used developer is then filtered and reused to develop additional precursors. Examples of developers used in such processes include 956 brand developer, MX 1813 brand developer and Aqua-Image brand developer, all of which are available from Kodak Polychrome Graphics.

During the development of a plurality of printing plate precursors, the activity of a developer (i.e. the ability of the developer to remove desired portions of the radiation-sensitive coating to produce an image) may vary due to the depletion of, or changes in, various components of the developer. In one example, the concentration of the active solvent or the dispersing agent may become depleted. In another example, the pH of the developer may vary. Changes in developer activity may be caused by loss of developer volume as printing plates carry developer out of the developer apparatus. Additionally, interactions with the radiation-sensitive coatings of the printing plate precursors may also affect developer activity. In particular, the pH of the developer may change due to acid/base interactions with radiation-sensitive coatings. This loss of developer activity may result in inconsistency in overall dot density over a cycle of developed printing plates, which may have adverse effects during printing.

Thus, in certain circumstances, developer activity may be restored, maintained or increased (collectively referred to herein as "maintain") through the addition of replenishers or regenerators to the volume of developer. As used herein, the term "replenisher" refers to a substance having approximately the same activity as the developer. Thus, the developer itself is often used as a replenisher to maintain the volume of developer contained in the developer system. As used herein, the term "regenerator" refers to a substance having a different level of activity than the developer to which it is added. For example, the regenerator may have a different pH or solvent concentration than the developer. Examples of such regenerators include 9008 brand regenerator, MX 1919 brand regenerator and Aqua-Image Top-Off brand regenerator, all available from Kodak Polychrome Graphics.

To accommodate the addition of replenisher or regenerator to the developer, development systems have been configured to include a vessel to house either replenisher or regenerator, and a conduit for controllably delivering replenisher or regenerator to the developer. Unfortunately, developer systems and methods that add either a replenisher or a regenerator to the developer do not necessarily provide an effective and efficient means to maintain developer activity.

In one embodiment, the present invention provides a system for developing printing plate precursors. The system includes a developer unit adapted to apply a developer to the printing plate precursors, a replenisher unit adapted to controllably deliver replenisher to the developer unit, and a regenerator unit adapted to controllably deliver the regenerator to the developer unit.

The developer unit may include a developing area adapted to receive printing plate precursors and to apply developer to the precursors, and a circulation unit adapted to receive developer from, and deliver developer to the developing area. The circulation unit may include a developer vessel adapted to receive developer from the developing area. The developer vessel may also receive replenisher delivered from the replenisher unit and/or regenerator delivered from the regenerator unit. The circulation unit may further include a developer filter positioned between the developing area and the developer vessel, as well as one or more controllable conduits adapted to provide fluid communication between the developing area and the developer vessel.

The replenisher unit may include a replenisher vessel to house replenisher and one or more controllable conduits to provide liquid communication between the replenisher unit and the developer unit. Likewise, the regenerator may include a regenerator vessel to house regenerator, and one or more controllable conduits adapted to provide liquid communication between the regenerator unit and the developer unit.

The system may also include one or more sensors to facilitate controlled delivery of the replenisher and/or the regenerator to the developer unit. In one embodiment, a sensor is adapted to monitor developer activity, such as the pH or the conductivity of the developer. In another embodiment, a sensor is adapted to monitor the number of printing plate precursors developed and/or the total area of developed precursor. Multiple sensors may be used in certain embodiments. The sensors may electronically communicate with the replenisher unit and/or the regenerator unit to deliver effective amounts of replenisher and/or regenerator to maintain developer activity.

The present invention also provides a method for treating a developer after developing a portion of at least one printing plate precursor. The method includes controllably delivering to the developer unit an effective amount of replenisher and regenerator to maintain developer activity, for example, the solvent concentration, the dispersing agent concentration, the pH or the conductivity of the developer. The replenisher and/or regenerator may be delivered as a function of developer activity, as a function of developed precursor area or a combination thereof.

In another embodiment, the present invention provides a system for developing printing plate precursors including a developer unit, a means for controllably delivering replenisher to the developer unit, and a means for controllably delivering regenerator to the developer unit.
Figure 1 is a schematic illustration of a conventional developer system.
Figure 2 is a schematic illustration of an alternate conventional developer system.
Figure 3 is a schematic illustration of an exemplary developer system of an embodiment of the present invention.

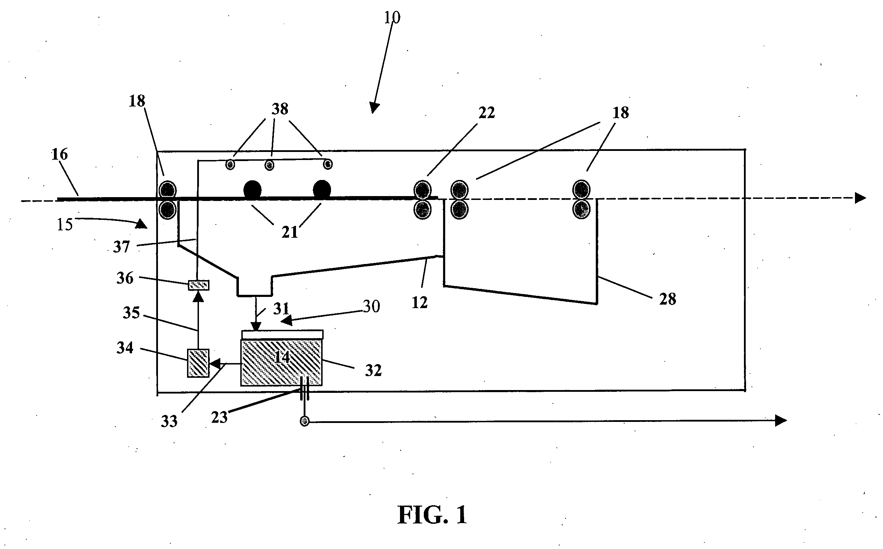

Conventional developer systems, such as the developer system 10 illustrated in Figure 1 includes a developer unit 15 which applies developer 14 to printing plate precursors 16. The developer unit 15 includes a developing area 12 which receives the precursors 16, brushes 21 to scrub the precursors 16, and sprayers 38 to apply or contact the aqueous developer 14 to the surface of the precursors 16. One or more guide rollers 18 drive and/or guide the precursors 16 through the developing area 12. At the exit of the developer unit 15, a water rinse tank 28 is adapted to remove excess developer from the developed printing plate. One or more rollers 22 serve to remove remaining developer 14 from the precursor 16 before the precursor 16 enters the water rinse tank 28. The developer system may also include a unit at the exit of the rinse tank 28 (not shown) that applies a gum or other desensitizer to protect the surface of developed printing plate.

The developer unit 15 further includes a circulation unit 30, which includes a developer vessel 32, a pump 34 and a filtration system 36. Conduit 31 connects the developing area 12 to the developer vessel 32, and outlet 23 drains excess solution from the developer vessel 32. The developer vessel 32 is connected to pump 34 via conduit 33. When pump 34 is activated, developer is delivered from the developer, vessel 32, through conduit 35 and filter 36. The developer then flows through conduit 37 to spray bars 38 in the developing area 12, where developer 14 is applied to the printing plate precursor 16. In this manner, developer 14 may be applied to printing plate precursors 16, filtered and then reused to develop additional printing plate precursors 16.

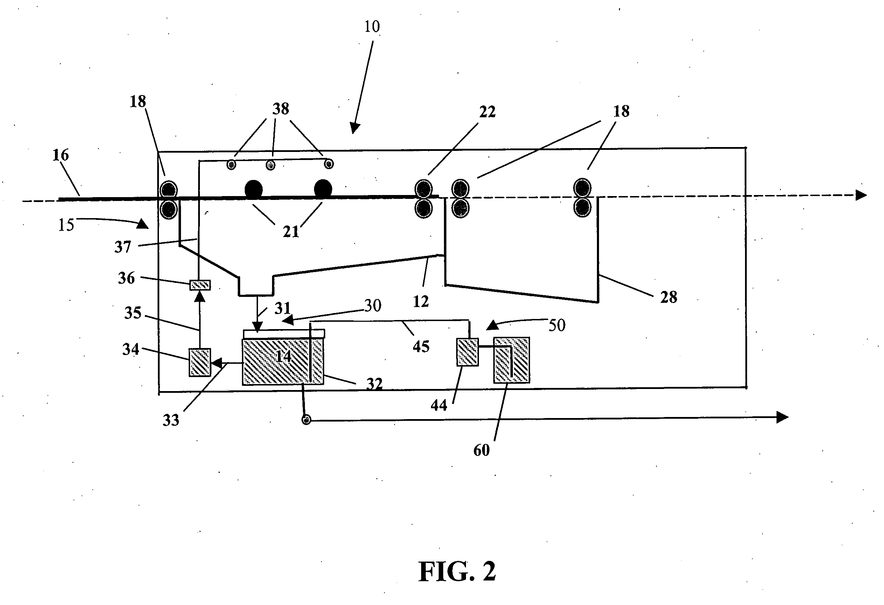

As shown in Figure 2, conventional developer systems may also include a replenisher unit 50, including a replenisher vessel 60, which is connected to developer vessel 32 via conduit 45 that includes pump 44. The replenisher unit 50 is adapted to controllably deliver replenisher to the developer unit 12.

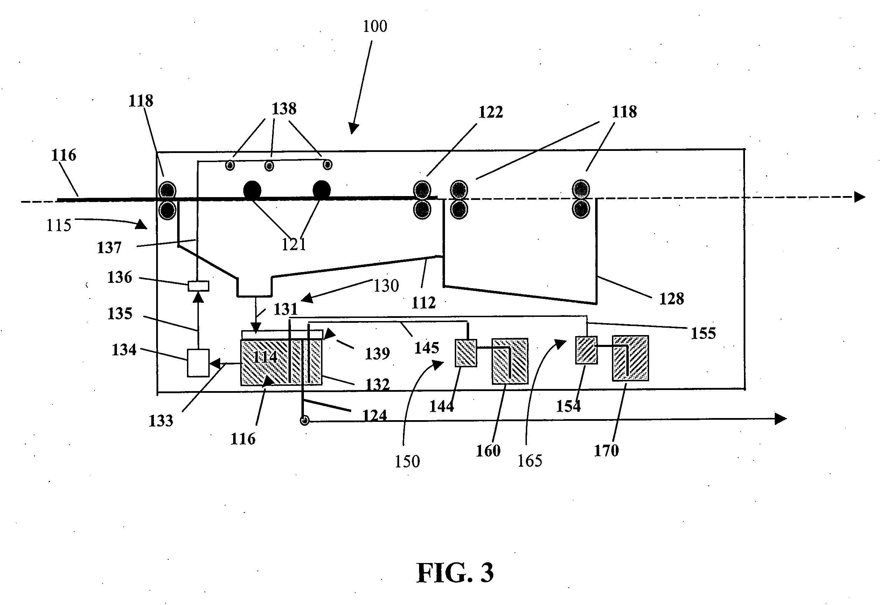

Figure 3 illustrates a developer system 100 according to an embodiment of the present invention. The developer system 100 in this embodiment includes both a replenisher unit 150 and a regenerator unit 165. The regenerator unit 165 includes a regenerator container 170 which is connected to developer vessel 132 via conduit 155 that include pump 154. A standpipe 124 is positioned relative to developer vessel 132 so that excess solution in the developer vessel 132 may be disposed of. The developer vessel 132 may also include an appropriate mixing device (not shown) to mix the replenisher and/or regenerator as it is added to the developer vessel 132. In this manner, the developer system illustrated in Figure 3 is adapted to controllably deliver both replenisher and regenerator to maintain the activity of the developer.

There are a variety of ways to provide controlled delivery of the replenisher and/or regenerator to the developer unit 115. In one embodiment, the developer unit 115 includes one or more sensors 139 for monitoring the volume or level of the developer in the developer vessel 132. If the developer volume or level is too low, the sensors 139 communicate with the replenisher unit 150 and/or the regenerator unit 165 to supplement the developer with replenisher and/or regenerator. Alternatively, sensors 139 may monitor the developed precursor area or number of developed precursors, and then communicate with the replenisher unit 150 and/or regenerator unit 165 to add a volume of replenisher and/or regenerator to the developer vessel 132 as a function of unit area of developed precursor. In another embodiment, replenisher and/or regenerator may be added as a function of the speed at which the developer system 100 develops the precursors 16. For example pumps 144 and/or 154 may be set to deliver a volume of replenisher and/or regenerator at predetermined time intervals. In yet a further embodiment, one or more sensors 139 may monitor the activity of the developer 114. For example, sensors 139 may monitor the pH or conductivity of the developer. If the activity varies beyond a certain amount, the sensors 139 communicate with one or both of the replenisher unit 150 and or the regenerator unit 165 to add additional replenisher and/or regenerator. In one embodiment, the sensors 139 may be configured to electronically communicate with pumps 144 and/or 154 to deliver the replenisher and/or the regenerator. Suitable sensor systems are available from Oakton Instruments, Vernen Hills, IL, and include the D.A.M. and Q.D.M. brand systems. An example of a particular pH sensor is the OAKTON pH/ORP Controller 800 series, available from Oakton Instruments.

Furthermore, combinations of these sensing methods may also be used to maintain developer activity. For example, a sensor 139 may monitor the number of plates or total plate area that has been developed to deliver a volume of replenisher per unit area of plate (or number of precursors) developed. However, the regenerator may be added to the developer vessel 132 by utilizing a pH sensor that communicates with pump 154 to deliver regenerator when the pH varies beyond a certain level. As is evident from the foregoing, the system 100 does not necessarily deliver replenisher and regenerator in the same amounts or at the same time. Likewise, the system 100 may provide for controlled delivery of the replenisher and the regenerator in different ways, so long as the system is capable of controllably delivering both replenisher and regenerator to the developer unit 112.

Although an embodiment of the present invention is illustrated in Figure 3, variations of that embodiment may also be suitable. For example, it is not necessary for the replenisher and/or regenerator to be added directly to the developer vessel 132. Instead, the replenisher and/or regenerator may be added to the developer at virtually any point after the developing area 12. Additionally, the developer system 100 could be modified to accommodate a developer unit 115 that applies developer by sending the printing plate precursors through a developer bath, rather than by spray application. In this embodiment, the circulation unit 130 may be positioned within the bath of developer to receive and deliver developer to the developing area. Further, the developer system 100 could be modified to develop 2-sided plates by adding additional sprayers 138 or by re-configuring the developer bath. Still further, the developer system 100 could be configured to include multiple developing areas 112 such that printing plate precursors 116 are developed in multiple stages. For example, the multiple developing areas 112 could be configured such that spent developer from the developing areas 112 is circulated into a first developing area, while the replenisher and regenerator are added only to remaining developing areas. In this manner, the final developing area or areas utilize developer having the desired level of activity.

The specific amount of regenerator and/or replenisher sufficient to maintain developer activity will vary based on a number of factors apparent to those of skill in the art. Such factors include the volume and specific type of developer, the composition of the printing plate precursors, the composition of the regenerator, the frequency of regenerator addition, the activity level being measured, and the surface area of printing plate precursors being developed. Furthermore, the developer system of the present invention is adapted to be used with a variety of developers, replenishers and regenerators to develop various types of printing plate precursors. Examples of suitable developers, replenishers, regenerators and printing plate precursors are reported, for example, in the United States Patent entitled "Developer Regenerators," attorney docket 58575-281077, which was filed on the same day as the present application, and which is incorporated herein by reference. In one embodiment, the developer is capable of developing printing plate precursors subjected to laser imaging, more particularly infrared laser imaging.

### EXAMPLE 1

A Sword Excel printing plate precursor was image-wise exposed with 830 nm radiation, using an internal test pattern on a Creo 3230 Trendsetter (exposure energy = 120 mjcm⁻²), available from Creo Products Inc., Burnaby, BC, Canada. The internal test pattern contained 1, 2, 3, 5, 10, 15, 20, 30, 40, 45, 50, 55, 60, 70, 80, 85, 90, 95, 98, 99, 99.5 and 100 percent dot images. The image-wise exposure was carried out using both Creo Staccato (FM) 10 micron and 20 micron screening.

The resulting imaged precursor was developed using an 850 Sword II plate processor, an 850 mm width processor as supplied by Glunz and Jensen, Elkwood, VA., in the following configuration:
- Developer = 956 Developer
- Developer filter = 20 inch, 15 micron wound from Stonehand (Denver, CO)
- Two plush rollers used in developer tank
- Processing speed = 3.5 ft/min
- Initial charge of developer = 10 gallons
- Developer replenishment rate = 2 ml/ft² of plate

The processor had been recently cleaned and new developer and filters installed. Plate resolution was then measured using a X-Rite 528 densitometer (CannonDirect, Bethel, Ohio).

After developing the imaged precursor, 100 square foot increments of exposed (as above, but with a solid, 100% exposure pattern, in AM mode) Sword Excel plate precursor ("bulk precursor") was developed through the processor to replicate pre-press environment.

After about 1500 ft² of bulk precursor had been developed, another Sword Excel printing plate precursor was imaged, developed and measured for resolution as above.

After about 2200 ft², of bulk precursor had been developed, another SWORD EXCEL precursor was imaged, developed and measured for resolution as above. Resolution for the each printing plate is shown in Table 1.

**Table 1**

| | 10 Micron Staccato Screen | | | | 20 Micron Staccato Screen | | |
|---|---|---|---|---|---|---|---|
| Area of Sword Excel Processed | 0 ft² | 1500 ft² | 2200 ft² | | 0 ft² | 1500 ft² | 2200 ft² |
| | | | | | | | |

| Theoretical dot / % | | | | | | | |
|---|---|---|---|---|---|---|---|
| 50 | 47 | 48 | 52 | | 46 | 48 | 50 |
| 60 | 56 | 57 | 62 | | 56 | 57 | 59 |

As demonstrated in Table 1, using 10 micron Staccato screening, dot percentages varied by 5 and 6 percent, respectively. With 20 micron Staccato screening, dot percentages varied by 4 and 3 percent, respectively.

### EXAMPLE 2

Precursors A, B and C, each SWORD EXCEL printing plate precursors, were image-wise exposed with 830 nm radiation, using an internal test pattern on a Creo 3230 Trendsetter (exposure energy = 120 mjcm⁻²) , available from Creo Products Inc., Burnaby, BC, Canada. The internal test pattern for each precursor included 50 percent dot images. The image-wise exposure for portions of each plate precursor was carried out using Creo Staccato (FM) 10 micron screening, Creo Staccato (FM) 20 micron screening and conventional (AM ) 200 lines/inch screening.

A 7500 square foot (in 100 square foot increments) cycle of bulk precursor imaged using a 100 percent exposure pattern was developed with an 85 NS plate processor, available from Technical Services International, Kennett Square, PA, which was modified to include a regenerator unit as shown in Figure 3, and an OAKTON pH/ORP Controller 800 Series pH sensor (in-line, continuous) from Oakton Instruments, Vernon Hills, IL. The processor was further modified to include a standpipe in the developer vessel (Fig. 3) to maintain a substantially constant volume. The modified processor was then configured as follows:
- Developer = 956 Developer
- Developer filter = 15 micron wound filter (Stonehand, Denver, CO.)
- Processing speed = 3.5 ft/min
- Initial charge of developer = 10 gallons
- Replenisher = 956 Developer
- Regenerator = Regenerator 1

956 Developer is an aqueous developer available from Kodak Polychrome Graphics, which includes a weak base, active solvent and dispersing agent, and has a pH of about 10. Table 2 below lists the components of Regenerator 1.

**Table 2**

| | | Regenerator 1 |
|---|---|---|
| | | |
| Water | | 601.88g |
| Silicone Antifoam Agent - DC Antifoam B - 15% | | 0.10g |
| Sodium Octyl Sulfate - 42% | | 120.50g |
| Sodium Methylnaphthalenesulfonate - 50% | | 88.90g |
| Triton H-66 - 42% | | 24.00g |
| Diethanolamine - 85% | | 12.00g |
| Trisodium Phosphate - 43.12% | | 9.20g |
| Sodium Hydroxide - 50% | | 50.00g |
| p-Toluenesulfonic Acid | | 0.92g |
| 2-Phenoxyethanol | | 44.20g |
| EDTA Tetra Sodium Salt | | 7.70g |
| Glycerin - 99.7% | | 40.60g |
| Total | | 1000.00g |
| | | |
| pH | | 13.30 |
| Conductivity (mS) | | 91.30 |

DC Antifoam B is available from Dow. Silicone Anti Foam Agent SE 57 is available from BYK Chemie, Wallingford, Connecticut. Triton H-66 is a phosphate ester available from Dow.

Precursors A, B and C were developed after 1000,4000 and 7000 ft², respectively, of bulk precursor had been developed. During the cycle, replenisher was added to the developer unit at a rate of about 2 ml per square foot of image precursor that was developed. Regenerator 1 was added to the developer as a function of the pH of the developer in the system. More particularly, the pH sensor was configured to electronically communicate with the regenerator pump when the pH of the developer dropped below 9.89. Table 3 shows the amount of regenerator used during the cycle, which averaged about 2 ml of regenerator per square foot of imaged precursor. The amount of regenerator used was measured by monitoring volume loss in the regenerator vessel.

**Table 3**

| **Square Footage** | **Regenerator(ml)** |
|---|---|
| 400 | 0 |
| 800 | 0 |
| 1200 | 2704 |
| 1600 | 0 |
| 2000 | 0 |
| 2400 | 0 |
| 2800 | 1217 |
| 3200 | 97 |
| 3600 | 1767 |
| 4000 | 270 |
| 4400 | 1866 |
| 4800 | 0 |
| 5200 | 168 |
| 5400 | 826 |
| 5600 | 1723 |
| 5800 | 137 |
| 6200 | 1370 |
| 6600 | 170 |
| 7000 | 461 |
| 7400 | 740 |
| 7500 | 1325 |
| | |
| **Total** | **14841** |
| | |
| **ml/ft**^{**2**} | **1.98** |

Dot densities for Precursors A, B and C were measured with a Greytag D196 densitometer after development. The results are summarized in Table 4.

**Table 4**

| | | Staccato 10 | | Staccato 20 | | Standard |
|---|---|---|---|---|---|---|
| Precursor (Sq Ft) | | (Stochastic 10 micron) | | (Stochastic 20 micron) | | AM Screening |
| A (1000) | | 41% | | 42% | | 45% |
| B (4000) | | 42% | | 42% | | 46% |
| C (7000) | | 43% | | 44% | | 46% |

The dot densities varied between one and two percent for the three screening methods, despite operating for three times the cycle length of Example 1. The dot density variation shown in Table 4 constitutes a significant improvement over the variation shown in Example 1, and is an acceptable level of variation in pre-press environment in many commercial applications.

## Claims

1. A system for developing printing plate precursors comprising:
a developer unit adapted to apply developer to the printing plate precursors;
a replenisher unit adapted to controllably deliver replenisher to the developer unit; and
a regenerator unit adapted to controllably deliver regenerator to the developer unit.

2. The system of claim 1 wherein the developer unit comprises:
a developing area adapted to receive printing plate precursors and to apply developer to the precursors; and
a circulation unit adapted to receive developer from and deliver developer to the developing vessel.

3. The system of claim 2 wherein the circulation unit further comprises a developer vessel adapted to receive and house developer from the developing area.

4. The system of claim 3 wherein the developer vessel is adapted to receive replenisher controllably delivered from the replenisher unit.

5. The system of claim 3 wherein the developer vessel is adapted to receive regenerator controllably delivered from the regenerator unit.

6. The system of claim 2 wherein the circulation unit further comprises a developer filter disposed between the developing vessel and the storage vessel.

7. The system of claim 2 wherein the circulation unit further comprises at least one controllable conduit adapted to provide fluid communication between the developing area and the circulation unit.

8. The system of claim 1 wherein the developer unit comprises at least one sprayer adapted to apply developer onto printing plate precursors.

9. The system of claim 1 wherein the developer unit comprises at least one scrubber adapted to contact a surface of the printing plate precursor.

10. The system of claim 1 wherein the developer unit comprises at least a first roller for receiving printing plate precursors.

11. The system of claim 1 wherein the replenisher unit comprises a replenisher vessel adapted to house replenisher.

12. The system of claim 1 wherein the replenisher unit comprises at least one conduit to adapted to provide controllable liquid communication between the replenisher unit and the developer unit.

13. The system of claim 1 wherein the regenerator unit comprises a regenerator vessel adapted to house regenerator.

14. The system of claim 1 wherein the regenerator unit comprises at least one conduit adapted to provide controllable liquid communication between the regenerator system and the developer system.

15. The system of any of claims 1 to 14 further comprising at least one sensor for monitoring developer activity.

16. The system of claim 15 wherein the sensor is adapted to monitor the pH or the conductivity of the developer.

17. The system of claim 15 wherein the sensor is adapted to monitor the volume of the developer in the developer unit.

18. The system of claim 15 wherein the sensor is adapted to monitor the developed precursor area or number of precursors developed.

19. The system of claim 15 wherein the sensor is adapted to control delivery of the replenisher, regenerator or both to the developer unit.

20. The system of claim 19 wherein the sensor electronically communicates with the replenisher unit, the regenerator unit or both to provide controllable delivery of the replenisher, the regenerator or both.

21. The system of claim 15 comprising a plurality of sensors.

22. The system of claim 15 comprising
a first sensor adapted to monitor developed precursor area or number of precursors developed and to communicate with the replenisher vessel to deliver a volume of replenisher as a function of unit area of developed precursor; and
a second sensor adapted to monitor developer activity and to deliver regenerator as a function of change in developer activity.

23. A method for treating a volume of developer after developing a portion of at least one printing plate precursor comprising delivering to the developer an effective amount of a replenisher and a regenerator to maintain the activity of the developer.

24. The method of claim 23 comprising delivering an effective amount of regenerator and replenisher to maintain the pH or conductivity of the developer.

25. The method of claim 24 wherein the replenisher, regenerator or both is delivered as a function of pH or conductivity change in the volume of developer.

26. The method of claim 23 comprising delivering an effective amount of regenerator and replenisher to maintain a solvent or dispersing agent concentration of the developer.

27. The method of claim 25 comprising delivering a volume of replenisher, regenerator or both after a predetermined precursor area or number of precursors has been developed.

28. The method of claim 23 comprising delivering a volume of replenisher, regenerator or both as a function of developing speed.

29. The method of claim 23 comprising delivering an effective amount of replenisher and regenerator to maintain the volume of the developer.

30. A method for developing a plurality of imaged printing plate precursors, the method comprising:
providing a developer system comprising a developer unit, a replenisher unit adapted to deliver replenisher to the developer unit and a regenerator unit adapted to deliver regenerator to the developer unit;
applying developer to a portion of at least one printing plate precursor in the developer unit;
delivering an effective amount of replenisher and regenerator to the developer unit to maintain the activity of the developer; and
applying developer to a portion of at least one additional printing plate precursor in the developer unit.

31. The method of claim 30 comprising delivering a volume of replenisher, regenerator or both to the developer unit after a predetermined precursor area or number of plates has been developed.

32. The method of claim 30 comprising delivering a volume of regenerator, replenisher or both to the developer unit as a function of change in developer activity.

33. The method of claim 32 comprising controllably delivering regenerator as a function of change in the pH or conductivity of the developer.

34. The method of claim 30 wherein the imaged printing plate precursor comprises a laser imaged printing plate precursor.

35. The method of claim 30 wherein the imaged printing plate precursor comprises an infrared laser imaged printing plate precursor.
